# EUROPEAN PATENT APPLICATION

(11) **EP 3 561 343 A1**
(43) Date of publication of application: **30.10.2019**
(21) Application number: 18191455.7
(22) Date of filing: 29.08.2018
(51) Int. Cl.: F16K 1/20, F16K 51/02, C23C 16/44, B01J 3/03, H01J 37/00

(54) **ISOLATION EQUIPMENT FOR PRECIPITATION CHAMBER**

(30) Priority: 24.04.2018 CN 201820592445 U
(71) Applicant: Beijing Juntailnnovation Technology Co., Ltd., Beijing 100176 (CN)
(72) Inventor: ZHAO, Yongfei, Beijing 100176 (CN)
(74) Representative: D'Halleweyn, Nele Veerle Trees Gertrudis

(57) **Abstract**

An isolation equipment for a precipitation chamber, for separating an inner cavity and an outer cavity of the precipitation chamber, includes a partition mechanism for closing the inner cavity. The partition mechanism includes a main door panel covering an opening of the inner cavity and an elastic device arranged to press the main door panel towards the inner cavity to tightly seal the inner cavity.

## Description

This disclosure claims the priority of the Chinese patent application No. 201820592445.7, entitled "Isolation Equipment for Precipitation Chamber" and filed on April 24, 2018, the entire content of which is hereby incorporated into this disclosure by reference.

### Technical Field

This disclosure relates to, but is not limited to, an equipment for manufacturing solar cells and, in particular, but is not limited to, an isolation equipment for a precipitation chamber.

### Background

Plasma Enhanced Chemical Vapor Deposition equipment (PECVD equipment) is a core equipment for manufacturing HIT high efficiency heterojunction cells. A PECVD precipitation chamber in the equipment is a chamber for depositing P/I/N junctions on silicon wafers.

The PECVD precipitation chamber includes an outer cavity and an inner cavity positioned inside the outer cavity. The side surface of the inner cavity is provided with an opening, and there is a need of isolating the outer cavity from the inner cavity when chemical vapor deposition is carried out. In a conventional technology, a door panel made of an aluminum plate with a thickness of 30 mm is used for isolation (i.e., the opening is blocked by the door panel to isolate the inner cavity from the outer cavity). The door panel moves in a vertical direction, and sealed isolation of the inner cavity and the outer cavity is achieved by using an O-shaped sealing ring on the door panel.

However, when the inner cavity is working at a high temperature, the sealing ring is easy to age and loses elasticity, so that there is a gap between the door panel and the inner cavity, thus the inner cavity and the outer cavity cannot be completely isolated. In addition, because the inner cavity is closed or opened by moving the door panel up and down in the vertical direction, the sealing ring will be frequently rubbed and damaged quickly, and the sealing ring need to be replaced frequently, bringing inconvenience to the use of the equipment.

### Summary

This disclosure provides an isolation equipment for a precipitation chamber, for separating an inner cavity and an outer cavity of the precipitation chamber. The isolation equipment includs a partition mechanism for closing the inner cavity, the partition mechanism includs a main door panel covering an opening of the inner cavity and an elastic device arranged to press the main door panel toward the inner cavity to seal the inner cavity.

### Brief Description of the Drawings

Fig. 1 is a schematic cross-sectional view of a partition mechanism according to an embodiment of this disclosure;
Fig. 2 is a schematic front structural view of an isolation equipment according to an embodiment of this disclosure;
Fig. 3 is a schematic right structural view of the isolation equipment shown in Fig. 2;
Fig. 4 is a schematic right structural view of an isolation equipment according to another embodiment of this disclosure.

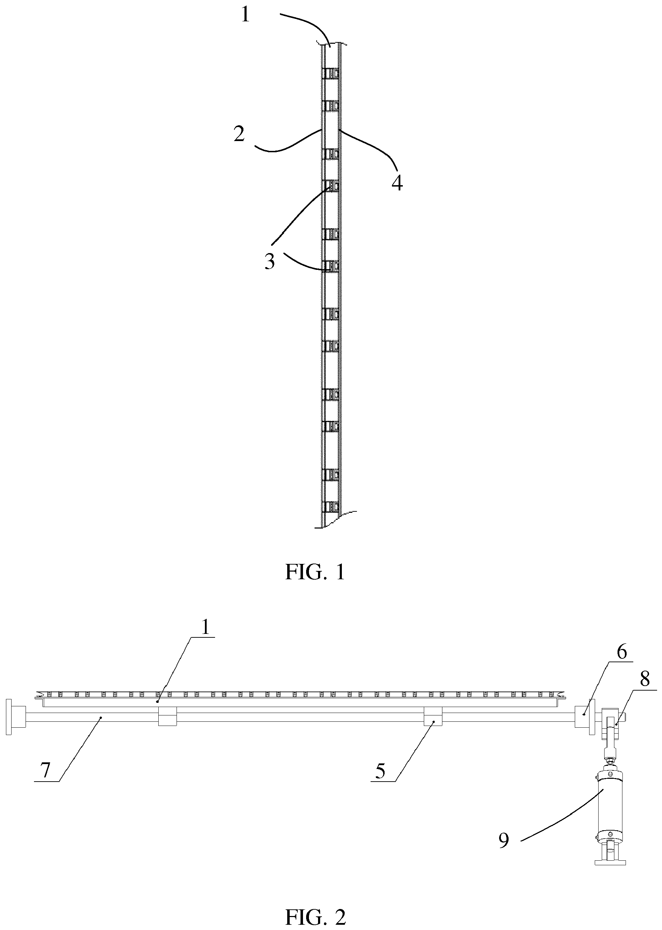

The correspondence between the reference numerals and the components in Figs. 1 to 4 is as follows:
1 -- partition mechanism, 2 -- main door panel, 3 -- elastic device, 4 -- substrate, 5 -- connecting seat, 6 -- bearing seat, 7 -- door spindle, 8 -- drive linkage, 9 -- cylinder, 10 -- drive rod, 11 -- hinging seat, 12 -- hinge pin, 13 -- drive pin.

### Detailed Description

Embodiments of the present disclosure will be described in detail below with reference to the accompanying drawings in order to make the objects, technical schemes and advantages of the present disclosure clearer. It should be noted that, in the case of no conflict, embodiments and features in the embodiments of the present disclosure may be combined with each other arbitrarily.

As shown in Fig. 1, an isolation equipment for separating an inner cavity and an outer cavity according to an exemplary embodiment includes a partition mechanism 1 for closing the inner cavity. The partition mechanism 1 includes a main door panel 2 and an elastic device 3 that are connected. The main door panel 2 can cover an opening of the inner cavity, and the elastic device 3 presses the main door panel 2 towards the inner cavity so that the main door panel 2 tightly seals the inner cavity, thereby realizing separation of the inner cavity and the outer cavity, avoiding the issue that the separation structure cannot completely separate the inner cavity and the outer cavity due to the failure of the sealing ring in the conventional technology, and besides, reducing the wear and tear of parts and the trouble caused by frequently replacing parts.

As shown in Fig. 1, the partition mechanism 1 includes a main door panel 2, an elastic device 3 and a substrate 4. The elastic device 3 is sandwiched between the main door panel 2 and the substrate 4, and one end of the elastic device 3 is connected to the main door panel 2 and the other end is connected to the substrate 4. The elastic device 3 can be a plurality of elastic pieces, one end of each elastic piece is abutted against the main door panel 2 to press the main door panel 2, and the other end is fixed to the substrate 4 that is connected and fixed to a drive device for moving the partition mechanism 1.

In an exemplary embodiment, when the inner cavity and the outer cavity are separated, the partition mechanism 1 is vertically arranged. The substrate 4 is defined by the drive device to fix relative to the inner cavity. The elastic pieces press the main door panel 2 toward the inner cavity to make it get close to the wall of the opening to seal the inner cavity, so that the partition mechanism 1 hermetically isolates the inner cavity and the outer cavity. The partition mechanism 1 can better absorb the deformation caused by an installation error and a high temperature for deposition, thus avoiding the issue that the inner cavity and the outer cavity cannot be completely isolated due to the failure of the sealing ring in the conventional technology, and besides, reducing the wear and tear of the sealing ring and the trouble caused by frequently replacing the sealing ring.

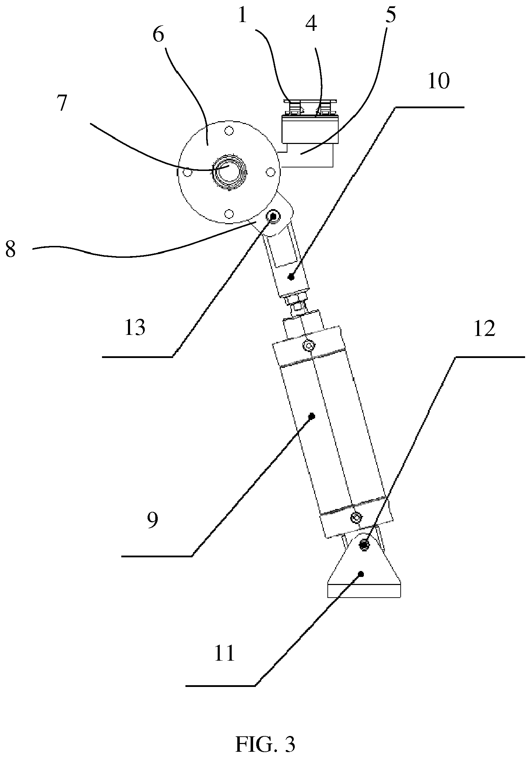

In another exemplary embodiment, as shown in Figs. 2 and 3, the partition mechanism is rotatably disposed.

The outer wall of the precipitation chamber is provided with a door spindle 7, as shown in Figs. 2 and 3, and bearing seats 6 are installed at both ends of the horizontal door spindle 7. Two bearing seats 6 are respectively fixed on both sides of the precipitation chamber so that the door spindle 7 can rotate around its own axis. In addition, a plurality of connecting seats 5 are fixed along the length direction of the door spindle 7 and arranged at equal intervals. The door spindle 7 is connected to the substrate 4 of the partition mechanism 1 by the connecting seats 5.

The isolation equipment also includes a drive device for providing power. As shown in Figs. 2 and 3, the drive device can be a cylinder 9 that is fixed at the outside of the inner cavity and connected to the door spindle 7, and is arranged to drive the door spindle 7 to rotate, thereby driving the partition mechanism 1 to rotate to cover or disengage the opening of the inner cavity. The cylinder 9 can be connected to the door spindle 7 by a linkage mechanism. Further, the linkage mechanism includes a drive rod 10 and a drive linkage 8. One end of the drive rod 10 is fixed to an output end of the cylinder 9 and is ensured to be arranged in the same direction as the output end of the cylinder 9, the other end of the drive rod 10 is hinged with the drive linkage 8 by a drive pin 13, and the drive linkage 8 is fixed to the door spindle 7, and the relative position of the drive linkage 8 and the connecting seat 5 is locked.

The bottom of the cylinder 9 can be fixed by a hinging seat 11 that is fixed at the outside of the inner cavity, and the cylinder 9 is hinged with the hinging seat 11 by a hinge pin 12.

When the isolation equipment does not separate the inner cavity from the outer cavity, the connecting seat 5 ensures that the partition mechanism 1 is horizontally arranged. When there is a need of separating the inner cavity from the outer cavity, a piston rod of the cylinder 9 extends outward, and the drive rod 10 rotates the drive linkage 8 by the drive pin 13, thus rotating the door spindle 7 and the connecting seat 5 at the same time. When rotating to 90 degrees, the partition mechanism 1 is vertically arranged to complete the isolation, and the inner cavity begins the process. When there is a need of communicating the inner cavity and the outer cavity again, only the cylinder 9 needs to continue to act, and the piston rod is retracted to rotate the door spindle 7 reversely. Therefore, the drive device of this embodiment isolates or communicates the inner cavity and the outer cavity by rotating the partition mechanism 1. Compared with the action mode of vertical movement in the conventional technology, it avoids the damage to various parts caused by frequent friction between the parts and can reduce the loss of equipment.

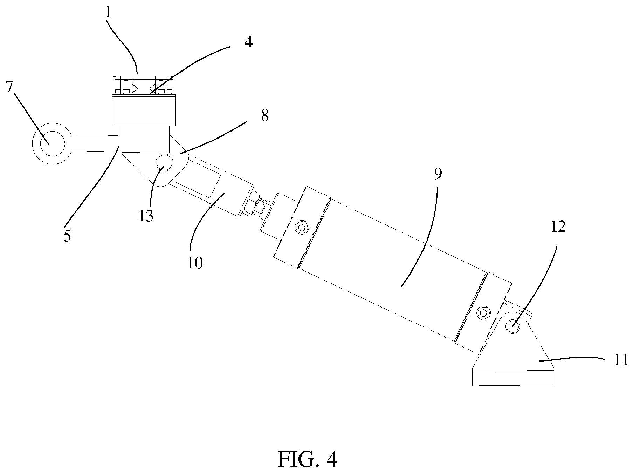

In yet another exemplary embodiment, as shown in Fig. 4, the drive device is connected to the partition mechanism.

A door spindle 7 is fixed on the wall of the precipitation chamber and is non-rotatable. As shown in Fig. 4, the partition mechanism 1 is rotatably mounted on the door spindle 7. The substrate 4 of the partition mechanism 1 is connected to the door spindle by a connecting seat 5, and one end of the connecting seat 5 is fixed to the substrate 4 and the other end is sleeved on the door spindle 7 so that the partition mechanism 1 can rotate around the door spindle 7. In addition, the isolation equipment also includes a cylinder 9 connected with the connecting seat 5 by a drive rod 10 and a drive linkage 8. One end of the drive rod 10 is fixed to the output end of the cylinder 9 and is ensured to be arranged in the same direction as the output end of the cylinder 9, and the other end of the drive rod 10 is hinged with the drive linkage 8 by a drive pin 13, while the drive linkage 8 is fixed on the connecting seat 5. In addition, the cylinder 9 is fixed at the outside of the inner cavity through a hinging seat 11 hinged thereto.

When the isolation equipment does not separate the inner cavity from the outer cavity, the connecting seat 5 ensures that the partition mechanism 1 is horizontally arranged. When there is a need of separating the inner cavity from the outer cavity, the piston rod of the cylinder 9 extends outward, and the drive rod 10 pushes the connecting seat 5 to rotate, thus rotating the partition mechanism 1. When the partition mechanism 1 is rotated to its vertical position, the isolation of the inner cavity from the outer cavity is completed, and the inner cavity begins the process. When there is a need of communicating the inner cavity and the outer cavity again, only the cylinder 9 needs to continue to act, and the piston rod is retracted so that the connecting seat 5 can rotate reversely.

The embodiments of this disclosure use a partition mechanism with an elastic device to hermetically isolate the inner cavity and the outer cavity, which can better absorb the deformation caused by an installation error and a high temperature for deposition, thus avoiding the issue that the inner cavity and the outer cavity cannot be completely isolated due to the failure of the sealing ring in the conventional technology, and besides, reducing the wear and tear of parts and the trouble caused by frequently replacing parts. The drive device of the embodiments of this disclosure closes or opens the inner cavity by rotating the partition mechanism, thus avoiding damage to parts caused by frequent friction compared with the action mode of vertical movement.

In the depictions of this disclosure, the terms "install", "join", "connect", "fix" and the like should be understood broadly. For example, the term "connect" may be a fixed connection, a detachable connection, or an integral connection, and it can be direct connection or indirect connection by an intermediate medium. For those of ordinary skill in the art, the specific meaning of the above terms in this disclosure can be understood according to the specific situation.

In the depictions of this specification, the statements of the terms "one embodiment", "some embodiments", "specific embodiments" and the like mean that a specific feature, structure, material, or characteristic described in connection with the embodiment or example is included in at least one embodiment or example of this disclosure. In this specification, the schematic expression of the above terms does not necessarily refer to the same embodiment or example. Furthermore, the specific features, structures, materials, or characteristics described may be combined in a suitable manner in any one or more embodiments or examples.

Although the embodiments disclosed in this disclosure are as above, the contents only are embodiments adopted for the convenience of understanding this disclosure and are not intended to limit this disclosure. Any person skilled in the art to which this disclosure belongs may make any modifications and changes in the forms and details of implementation, without departing from the spirit and scope of the disclosure, but the patent protection scope of this disclosure should still be subject to the scope defined in the appended claims.

## Claims

1. An isolation equipment for a precipitation chamber, for separating an inner cavity and an outer cavity of the precipitation chamber, the isolation equipment comprising a partition mechanism (1) for closing the inner cavity, the partition mechanism (1) comprising a main door panel (2) covering an opening of the inner cavity and an elastic device (3) arranged to press the main door panel (2) toward the inner cavity to seal the inner cavity.

2. The isolation equipment according to claim 1, wherein the partition mechanism (1) further comprises a substrate (4), and the elastic device (3) is disposed between the main door panel (2) and the substrate (4).

3. The isolation equipment according to claim 2, wherein the substrate (4) is rotationally connected with the precipitation chamber.

4. The isolation equipment according to claim 1, wherein the main door panel (2) is connected to the elastic device (3).

5. The isolation equipment according to claim 3, wherein the precipitation chamber is provided with a rotatable door spindle (7), the substrate (4) is fixed on the door spindle (7), the isolation equipment further comprises a drive device connected to the door spindle (7) and arranged to drive the door spindle (7) to rotate, and the partition mechanism (1) rotates in association with the door spindle (7).

6. The isolation equipment according to claim 3, wherein a door spindle (7) is fixed on the precipitation chamber, the substrate (4) is rotatably mounted on the door spindle (7), and the isolation equipment further comprises a drive device connected to the substrate (4) and arranged to drive the partition mechanism (1) to rotate around the door spindle (7).

7. The isolation equipment according to claim 5 or 6, wherein a connecting seat (5) is fixed on the substrate (4), and the connecting seat (5) is mounted on the door spindle (7) by the connecting seat (5).

8. The isolation equipment according to claim 5 or 6, further comprising:
a linkage mechanism connected to the drive device, and the drive device drives the partition mechanism (1) to rotate by the linkage mechanism.

9. The isolation equipment according to claim 8, wherein the drive device is a cylinder (9) fixed on the outside of the inner cavity, the linkage mechanism comprises a drive rod (10) and a drive linkage (8), one end of the drive rod (10) is fixed to an output end of the cylinder (9), and the other end of the drive rod (10) is hinged with the drive linkage (8).

10. The isolation equipment according to claim 9, further comprising:
a hinging seat (11) fixed on the outside of the inner cavity, the cylinder (9) being hinged on the hinging seat (11).

11. The isolation equipment according to claim 5 or 6, wherein the door spindle (7) is installed on the outside of the inner cavity through bearing seats (6) provided at both ends of the door spindle (7).

12. The isolation equipment according to any one of claims 1-4, wherein the elastic device (3) comprises a plurality of elastic pieces.
